# EUROPEAN PATENT SPECIFICATION

(11) **EP 1 753 037 B1**
(45) Date of publication and mention of the grant of the patent: **18.05.2011**
(21) Application number: 06021272.7
(22) Date of filing: 07.07.1998
(51) Int. Cl.: H01L 33/50

(54) **Transparent coating member for light-emitting diodes and fluorescent color light source**
Durchsichtige Beschichtung für Leuchtdioden und Fluoreszierende Lichtquelle
Revêtement transparent pour des diodes électroluminescentes et source de lumière fluorescente

(30) Priority: 07.07.1997 JP 18103597
(43) Date of publication of application: 14.02.2007
(62) Divisional of application: 98112602.2
(73) Proprietor: Asahi Rubber Inc., Omiya-ku Saitama-shi, Saitama (JP); SANKEN ELECTRIC CO., LTD., Niiza-shi Saitama (JP)
(72) Inventor: Tasaki, Masutsugu c/oAsahi Rubber Inc., Nishishirakawa-gun Fukushima-ken (JP); Ichikawa, Akira c/oAsahi Rubber Inc., Nishishirakawa-gun Fukushima-ken (JP); Odaki, Tsutomu c/oAsahi Rubber Inc., Nishishirakawa-gun Fukushima-ken (JP); Takagi, Kazuhisa c/oK.K. Fine Rubber Kenkyuusho, Nishishirakawa-gun Fukushima-ken (JP)
(74) Representative: Müller-Boré & Partner Patentanwälte

(56) References cited:
- WO-A-97/50132
- DE-A- 3 804 293
- JP-A- 1 260 707
- JP-A- 6 104 491
- US-A- 3 932 881
- US-A- 3 959 655
- US-A- 4 599 537
- SUMIMURA S ET AL: "OPTICALLY TRANSPARENT SILICONE ELASTOMERS", INTERNATIONAL POLYMER SCIENCE AND TECHNOLOGY, RAPRA TECHNOLOGY, SHREWABURY, GB, vol. 16, no. 7, 1 January 1989 (1989-01-01), pages T41-44, XP000115432, ISSN: 0307-174X
- MILLER R E: "Guidelines for selecting elastomeric silicone encapsulants", ELECTRI-ONICS, LAKE PUBLISHERS CO., LIBERTYVILLE, IL, US, vol. 30, no. 10, 1 September 1984 (1984-09-01), pages 49-51, XP008123316, ISSN: 0745-4309

## Description

### BACKGROUND OF THE INVENTION

This invention relates to a transparent coating member in the form of a sheet to be mounted on a light-emitting diode (hereinafter, "LED") and a light source for changing the color of a light emitted from an LED by mounting the coating member in the form of a sheet on the LED or forming a coating layer containing a fluorescent substance on the surface of the LED.

As well-known, a LED chip is a crystal body having a p-n junction. Upon the application of a forward voltage, electrons are injected from the n region to the p-n junction and holes are injected from p region to the p-n junction. A light is emitted when the electrons and holes are recombined. Accordingly, free electrons are combined and energy released during this recombination is radiated as a light. Thus, there exist LEDs of limited colors. In other words, LEDs having a red LED chip emit only a red light; LEDs having a green LED chip emit only a green light; and LEDs having a blue LED chip emit only a blue light.

However, there has recently been a large demand for LEDs capable of changing a light emitted therefrom in order to meet multi-purpose applications. A color changing method for meeting such a demand is, for example, such that a suitable combination of red, green and blue LED chips are set in the LED and the color of the light emitted from the LED is changed by causing a different combination of chips to emit light.

Such an LED results in a complicated constructional design since four terminals: three different anode terminals of the red, green and blue LED chips and a cathode terminal, are necessary. The most fatal problem is that, since three different chips are set in the LED, a color balance is lost if any one of the chips is broken, with the result that a desired color cannot be obtained.

Further, in recent years, a white LED lamp has been proposed in which a layer of YAG (yttrium aluminate) fluophor is provided on a blue LED chip (Nikkei Sangyo Shinbun, Sept. 13, 1991 issue). This white LED lamp is designed to generate a white light by a light excited by the layer of fluophor and the afterglow of the blue LED chip. If a cap or a sheet containing a coloring agent is mounted on such a white LED lamp, a light of a desired color can be obtained.

However, the above white LED lamp has various problems that a high degree of application technique is required due to only a very small amount of fluorescent substance on the blue LED chip, a large variation of the color caused by a slight error and the application of a fine amount, and a price per lamp is very expensive.

On the other hand, it is in reality very difficult to produce LEDs of uniform quality, and the color and luminance of the produced LEDs unavoidably vary. It is a very important problem how such variations can be suppressed without increasing production costs. Up to now, the variations have not yet sufficiently been suppressed.

DE 3804293 A1 discloses a light source comprising a light emitting diode chip, whose emitting surface is covered by a transparant coating member made of polycarbonate and comprising an organic fluorescent substance.

US 3959655 discloses a light source comprising a light emitting diode chip, whose emitting surface is covered by a thin sheet of transparent material comprising a fluorescent dye used to concentrate the output of the light emitting diode chip to a fine line .

US 4 599 537 discloses a light source constituted so that infrared rays and visible rays can be simultaneously emitted. The light source comprises a sealed infrared light emitting diode chip and an infrared /visible light conversion member made of silicon rubber and comprising an inorganic fluorescent substance.

### SUMMARY OF THE INVENTION

The present invention has been developed as a result of studies to solve the above-mentioned various problems and an object thereof is to provide a transparent coating member for a LED which can easily change the color of a light emitted therefrom to a desired color.

It is another object of the present invention to provide a fluorescent color light source which can easily change the color of a light irradiated therefrom and diffuse the light of a stable color at a high luminance and is easy to maintain and inexpensive.

The invention is directed to a transparent coating member according to claim 1.

The invention is also directed to a fluorescent color light source according to claim 6.

These and other objects, features and advantages of the present invention will become more apparent upon a reading of the following detailed description and accompanying drawings.

### BRIEF DESCRIPTION OF THE DRAWINGS

FIG. 1 is a schematic section of a fluorescent color light source not forming part of the present invention in which a fluorescent color cap as a coating member (cap-shaped) is mounted on a lamp-type LED;
FIG. 2 is a schematic section of a fluorescent color light source not forming part of the present invention in which a fluorescent color cap as another coating member (cap-shaped) is mounted on the lamp-type LED;
FIGS. 3A and 3B are schematic sections of fluorescent color light sources in which a coating member (sheet-shaped) as an embodiment of the present invention is mounted on a chip-type LED and a segment-type LED, respectively;

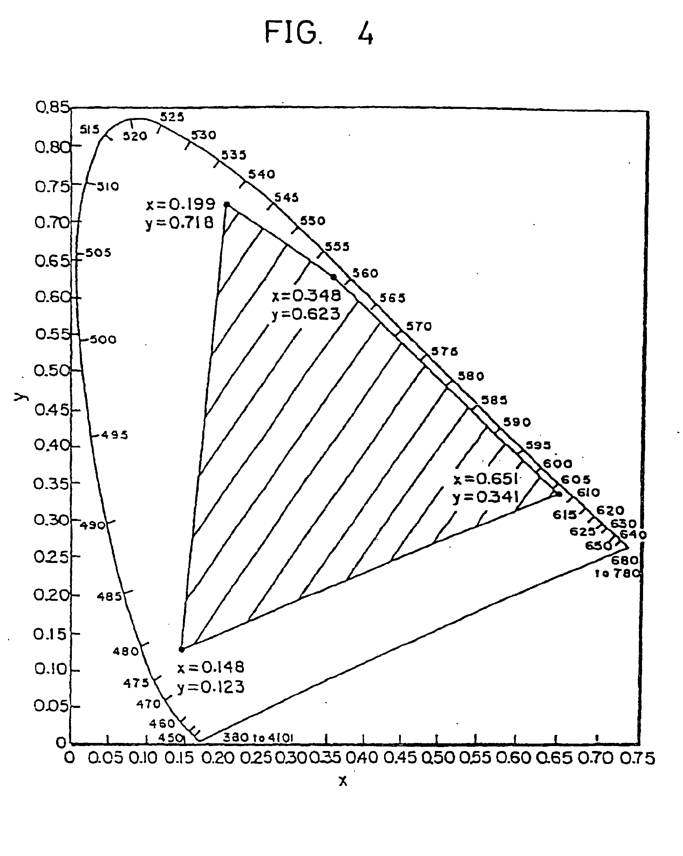

FIG. 4 is a chart showing a variable range of a light diffusely emitted from the fluorescent color source of the invention by CIE (International Committee on Illumination) standard chromaticity diagram;
FIG. 5 is a section of a fluorescent color cap not forming part of the present invention in which a light gathering mechanism is provided at its leading end portion;
FIG. 6 is a graph showing a spectral wavelength of a blue LED used in a production example 23;
FIG. 7 is a graph showing a spectral wavelength when the fluorescent color cap is mounted on the blue LED in the production example 23;
FIG. 8 is a graph showing a spectral wavelength when an elastic sheet containing a fluorescent substance is mounted on a blue LED in a production example 24;
FIG. 9 is a graph showing a spectral wavelength when a colored cap is mounted in a production example 28;
FIG. 10 is a graph showing a spectral wavelength when a colored cap is mounted in a production example 29; and
FIG. 11 is a graph showing a spectral wavelength when a fluorescent color cap is mounted in a production example 32.

### DETAILED DESCRIPTION OF THE PREFERRED EMBODIMENTS OF THE INVENTION

The significant feature of the transparent coating member for an LED according to the invention lies in the fluorescent substance contained therein. As opposed to the prior art method for generating a light of a desired color by applying a fine amount of fluorescent substance to the LED chip, light of a desired color can be generated by mounting the inventive transparent coating member on an LED without necessitating a high level of technique.

The fluorescent substance may be preferably an yttrium aluminate fluophor Further, the coating member is sheet-shaped.

Also, a fluorescent color light source is produced by mounting a transparent coating member on a light-emitting diode or forming a coating layer containing a fluorescent substance on the surface of the light-emitting diode to thereby change the wavelength of an emitted light peculiar to the light-emitting diode by the fluorescent substance contained in the coating member or coating layer, and thereby change the luminescent color.

The fluorescent color light source is such that the light diffusely emitted through the coating member or coating layer has a luminescent color within a range defined by (x, y) = (0.148, 0.123), (0.199, 0.718), (0.651, 0.341) and (0.343, 0.623) in chromaticity coordinate systems, and more preferably in a range defined by (x, y) = (0.27, 0.19), (0.19, 0.24), (0.35, 0.48) and (0.48, 0.37) in chromaticity coordinate systems. The fluorescent color light source may be such that a coating member or coating layer containing a coloring agent is further mounted or formed on the coating member or coating layer. Preferably, a holder mechanism may be provided in a desired position of contact surface of the light-emitting diode and the coating member. The light-emitting diode on which the coating member or coating layer may be preferably mounted or formed is a blue light-emitting diode or green light-emitting diode having a high energy.

The color of emitted light to be diffused while passing through the coating member can be adjusted by partially changing the concentration of the fluorescent substance in the coating member. For example, with reference to a production example 33 to be described later, if the fluorescent substance is uniformly and dispersely mixed in a fluorescent color cap, a light emitted through a leading end portion of the cap is: x = 0.2346, y = 0.2365 and a light emitted through a side surface portion of the cap is: x = 0.3095, y = 0.3389. In other words, the color of the emitted light differs depending on whether the light passes through the leading end portion of the cap or the side surface portion thereof. If another cap containing a specified amount of fluorescent substance is further mounted on the leading end portion of the cap, i.e. the concentration of the fluorescent substance is changed at the leading end portion and the side surface portion, the light emitted through the leading end portion is: x = 0.3060, y = 0.3355 and is the same color as the color of the light emitted through the side surface portion.

Fluorescent substances usable for the inventive transparent coating member for an LED are inorganic fluophors including aluminates, phosphates, silicates. Among these substances, yttrium aluminate is particularly preferable since it is usable over a long term.

Additives to be added to the fluophors include, for example, cerium, europium, manganese, gadolinium, samarium, terbium, tin, chromium, etc. Cerium is most preferable among these. An amount of additive is preferably in a range of 0.1 to 10 mol% to the fluophor.

A preferable combination of the fluophor and additive are yttrium aluminate and cerium.

The mode of the inventive transparent coating member for an LED is a sheetlike shape in conformity with the shape of the LED. In order to make the coating member into a sheetlike shape, the fluorescent substance and a bonding resin may be melted and kneaded and may be molded according to an inflation method, T-die extrusion, solvent casting, calendering. Further, a sheetlike shape may be realized by coating the fluorescent substance on a base sheet made of a plastic film. As such a coating method may be adopted a method for applying a fluorescent substance dissolved in an organic solvent to the base sheet and drying it by hot air or a method for applying a synthetic resin emulsion to the base sheet and drying it to form a polymer film thereon.

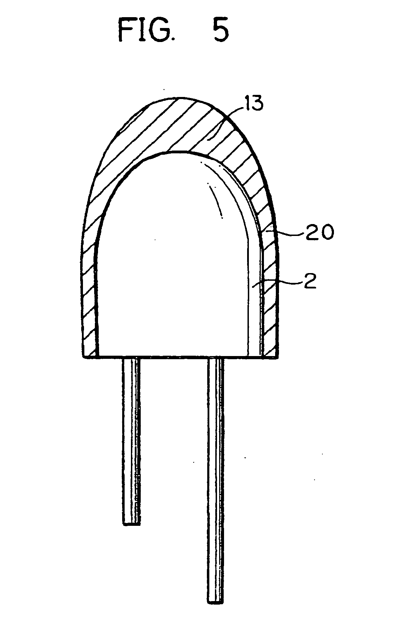

In the case that the transparent coating member for an LED is cap-shaped, not forming part of the present invention, a light gathering mechanism may be provided at its leading end portion. Luminance can be increased by such a mechanism, thereby achieving an efficient illumination with a little energy. The light gathering mechanism may be constructed, for example, by a lens construction. A specific example of construction is shown in FIG. 5. A light gathering portion may be provided at the leading end portion of the cap by being integrally molded with other parts using a mold in which the leading end portion is thicker than the other parts or by adhering or mounting a separately manufactured light gathering portion on the leading end portion of the cap.

An amount of the fluorescent substance used in the coating member is in a range of 0.5 to 70 weight parts per 100 weight parts of bonding resin.

Resins usable for the coating member according to the invention include,

Any known LED can be used as an LED used in the present invention. For example, Ga:ZnO red LED, GaP:N green LED, GaAsP red LED, GaAsP orange/yellow LED, GaAlAs LED, InGaAlP orange/yellow LED, GaN blue LED, SiC blue LED, II-VI blue LED may be used.

Further, the LED comes in any mode. For example, a LED lamp, a chip type LED or a segment type LED, etc. may preferably be used.

The wavelength of the light emitted from the LED can be changed to a desired one by mounting the above coating member on the LED or forming a coating layer containing a fluorescent substance on the surface of the LED.

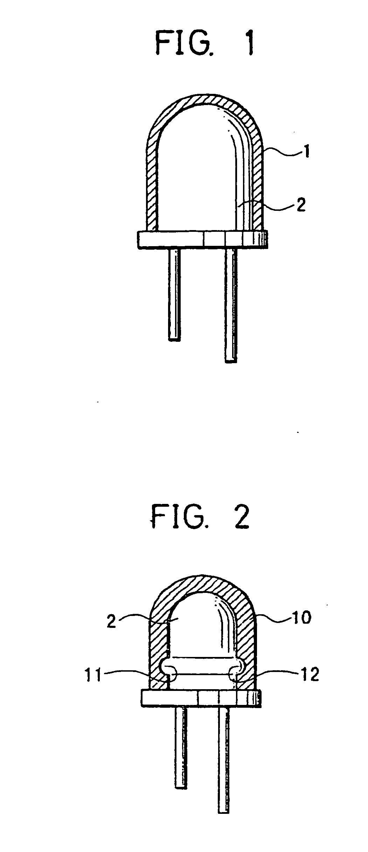

In order to mount the coating member on the LED, it may be engaged with the LED in the case of a cap-shaped coating member, not forming part of the present invention. In order to more securely mount the coating member, a holder mechanism may be provided at a peripheral portion of the coating member. With reference to FIG. 1, not forming part of the present invention, an inventive coating member (cap) 1 containing a fluorescent substance is directly detachably mounted on an LED 2. Since a cap 10 shown in FIG. 2, not forming part of the present invention, is relatively hard, a recess 11 is formed in the cap 10 and a projection 12 is formed on the LED 2 in order to prevent a relative displacement and a disengagement when the cap 10 is mounted on the LED 2. The cap 10 and the LED 2 are disengageably engaged with each other by one operation. The recess 11 and the projection 12 may have an annular configuration along the circumference of the cap or may be formed in a plurality of positions along a circumferential direction at specified intervals. Further, the recess 11 and the projection 12 may be formed on the LED 2 and the cap 10, respectively, converse to the former construction.

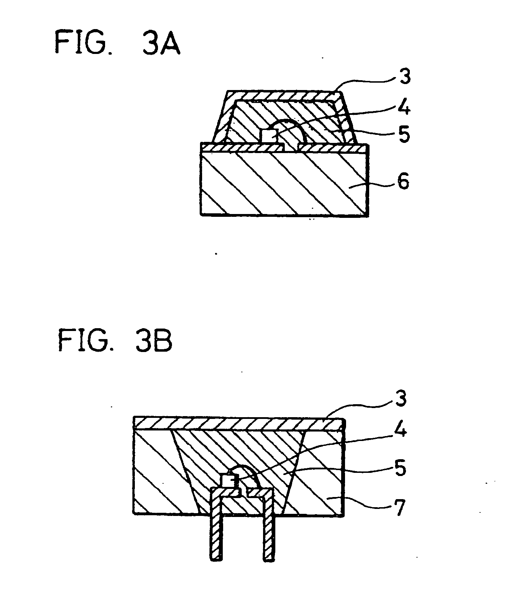

In the case of the sheet-shaped coating member, it may be placed on the surface of the LED. At this time, it is preferable to adhere the sheet-shaped coating member to the LED. A known method such as a thermal adhesion, ultrasonic sealing, high-frequency bonding or a gluing using an adhesive or the like may be used as a method for adhering the sheet-shaped coating member to the LED. Here, in order to improve adhesiveness, the surface of the sheet-shaped coating member may be oxidized by chemicals or by being subjected to gas flames or by means of corona discharge by being brought into contact with a surface electrode. For example, FIGS. 3A and 3B are side views in section of fluorescent color light sources in which sheet-shaped coating members are mounted on LEDs. A sheet-shaped coating member 3 is mounted on a chip type LED in FIG. 3A, while being mounted on a segment type LED in FIG. 3B.

In order to form a coating layer containing the fluorescent substance on the surface of the LED, a known method such as a resin coating or a printing method may be adopted. For example, a bonding resin may be dissolved in a solvent and coated on the surface of the LED after the fluorescent substance is added thereto.

The color of the light diffusely emitted from the LED having the coating member mounted thereon or having the coating layer formed thereon is preferably in a range defined by (x, y) = (0.148, 0.123), (0.199, 0.718), (0.651, 0.341), (0.343, 0.623) in the chromaticity coordinate systems. If the emission would fall within such a range, a variety of illuminations could be realized and a color reproduction as a video image is thought to be sufficient. Further, if the color of the emitted light is in a range defined by (x, y) = (0.27, 0.19), (0.19, 0.24), (0.35, 0.48), (0.48, 0.37) in the chromaticity coordinate systems, i.e. it is close to white, the color of the emitted light can easily be adjusted to a desired color.

In other words, if the color of the light emitted from the LED is adjusted to white by mounting or forming the coating member or coating layer, the emitted light can be adjusted to have a desired color by using a coloring agent. In such a case, the coloring agent may be contained in the coating member or coating layer together with the fluorescent substance or a separate coating member or coating layer containing the coloring agent may further be mounted or formed thereon.

The following can be used as a coloring agent. For example, yellow led, yellow zinc, cadmium yellow, yellow iron oxide, mineral fast yellow, nickel titanium yellow, naphthol yellow S, Hansa yellow G, Hansa yellow 10G, benzine yellow G, benzine yellow GR, guinoline yellow lake, permanent yellow NCG, tartrazine lake can be used as a yellow pigment. Chrome orange, molybdenum orange, permanent orange GTR, pyrazolone orange, vulcan orange, benzine orange G can be used as an orange pigment. Condensation azo dye, red iron oxide, cadmium red, red lead, cadmium mercuric sulfide, permanent red 4R, lithol red, pyrazolone red, watching red calcium salt, lake red D, brilliant-carmine 6B, eosine lake, rhodamine lake B, alizarin lake, brilliant-carmine 3B can be used as a red pigment. Manganese violet, fast violet B, methyl violet lake can be used as a violet pigment. Iron blue, cobalt blue, alkali blue lake, Victoria blue lake, phthalocyanine blue, metal-free phthalocyanine blue, phthalocyanine blue partial chloride, fast sky blue can be used as a blue pigment. Chrome green, chromium oxide, pigment green B, malachite green lake can be used as a green pigment. Hydrozincite, titanium oxide, antiony white, zinc sulfide, barite powder, barium carbonate, clay, silica, white carbon, talc, alumina white can be used as a white pigment. It is appropriate to use the above coloring agents in a range of 0.001 to 0.1 weight part, particularly 0.01 to 0.05 weight parts per 100 weight parts of bonding resin.

The LED on which the above coating member or coating layer are mounted or formed is preferably a blue LED having a high energy. However, it may be a green LED or other LED.

By using the coating member according to the invention, the luminescent color can finely be adjusted. For example, this coating member makes LEDs having an emitted light beyond a permissible range due to a variation during the manufacturing into a one having an emitted light within this permissible range. With reference to a production example 34, not forming part of the present invention, a desired luminescent color within a range of x = 0.2886 to 0.3046, y = 0.3102 to 0.3165 can be obtained by mounting a fluorescent color cap containing 10.0 parts of YAG fluophors, 10.5 parts thereof, 11.0 parts thereof, and 11.5 parts thereof on the LED when, for example, a current flowing into a blue LED is 5mA, 10mA, 20mA and 30mA, respectively. It should be noted that the observation or measurement was carried out by means of a spectrophotometer "PR-704" through an integrating sphere or not through an integrating sphere.

### [Examples]

### Production Example 1, not forming part of the present invention.

1.5 parts of NKP-8306 (fluophor produced by Nippon Keiko Kagakusha) were dispersed as fluorescent substance in silicone rubber, and a fluorescent color cap having a thickness of 0.5 mm was molded using a mold and a heat press. Further, a blue LED which emits a light defined by x = 0.1490, y = 0.1203 in accordance with the CIE (Committee on International Illumination) standard calorimetric system (hereinafter, "chromaticity coordinate systems") was used. When this blue LED was caused to emit a light with the fluorescent color cap mounted thereon, a diffused white light having a yellow tint which is defined by x = 0.3912, y = 0.4322 in the chromaticity coordinate systems was observed. In this example, the measurement was carried out through the integrating sphere.

In the above case, the luminance of the blue LED itself was 32 cd/m². However, by mounting the fluorescent color cap according to the invention to change the color, the luminance is increased to 66 cd/m². Directivity peculiar to the LED is reduced and the luminescent color was diffused by the entire surface of the fluorescent color cap.

### Production Example 2, not forming part of the present invention

An amount of NKP-8306 (fluophor produced by Nippon Keiko Kagakusha) added was changed from 1.25 parts to 1.07 parts to 0.94 parts to 0.83 parts, and to 0.75 parts. These various amounts of NKP-8306 were dispersed as fluorescent substance in silicone rubber, and fluorescent color caps having a thickness of 0.5 mm were molded using the same mold and heat press as the example 1. Further, these fluorescent color caps were mounted on blue LEDs which emit a light defined by x = 0.1490, y = 0.1203 in accordance with the chromaticity coordinate systems, and the blue LEDs were caused to emit a light. TABLE-1 below shows the resulting colors of the diffused emitted lights. In this example, the measurement was carried out through the integrating sphere.

**TABLE-1**

| Fluorescent | Chromaticity | Luminescent |
|---|---|---|
| Substance | Coordinates | Color |
| 1.25 Parts | X = 0.3752 | White |
| Dispersed | Y = 0.4153 | |
| 1.07 Parts | X = 0.3460 | White |
| Dispersed | Y = 0.3901 | |
| 0.94 Parts | X = 0.3319 | White |
| Dispersed | Y = 0.3780 | |
| 0.83 Parts | X = 0.3094 | White having |
| Dispersed | Y = 0.3536 | a blue tint |
| 0.75 Parts | X = 0.2916 | White having |
| Dispersed | Y = 0.3368 | a blue tint |

As is clear from the results of TABLE-1, it was confirmed that the amount of fluorescent substance added could control the luminescent color. Particularly in the above case, it was observed that luminance of the emitted light was highest at 70 cd/m² when 1.25 parts of fluorescent substance was dispersed. The thickness of the fluorescent color cap according to the invention may be uniform or may partially be varied to diffuse the light or change the color thereof. Fluorescent color cap can be designed according to the purpose.

### Production Example 3, not forming part of the present invention

NKP-8306 (fluophor produced by Nippon Keiko Kagakusha) and gadolinium oxide as an additive were mixed at a ratio of 10:2. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.2971, y = 0.3485 in the chromaticity coordinate systems was observed. In this example, the measurement was carried out through the integrating sphere.

### Production Example 4, not forming part of the present invention

NKP-8306 (fluophor produced by Nippon Keiko Kagakusha) and gadolinium oxide as an additive were mixed at a ratio of 10:4. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.2985, y = 0.3529 in the chromaticity coordinate systems was observed. In this example, the measurement was carried out through the integrating sphere.

### Production Example 5, not forming part of the present invention

NKP-8306 (fluophor produced by Nippon Keiko Kagakusha) and gadolinium oxide as an additive were mixed at a ratio of 10:6. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.3090, y = 0.3679 in the chromaticity coordinate systems was observed. In this example, the measurement was carried out through the integrating sphere.

### Production Example 6, not forming part of the present invention

NKP-8306 (fluophor produced by Nippon Keiko Kagakusha) and gadolinium oxide as an additive were mixed at a ratio of 10:8. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.3138, y = 0.3734 in the chromaticity coordinate systems was observed. In this example, the measurement was carried out through the integrating sphere.

### Production Example 7, not forming part of the present invention

NKP-8306 (fluophor produced by Nippon Keiko Kagakusha) and gadolinium oxide as an additive were mixed at a ratio of 10:10. This mixture was dispersed in 0.75 parts of silicone rubber and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a blue tint which is defined by x = 0.3254, y = 0.3890 in the chromaticity coordinate systems was observed. In this example, the measurement was carried out through the integrating sphere.

As is clear from the results of the luminescent colors of the examples 3 to 7 described above, it was confirmed that a wavelength of the blue LED is more effectively excited by increasing an added amount of gadolinium.

### Production Example 8, not forming part of the present invention

5 parts of StellarGreen E-8 (fluophor produced by Swada) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused vivid green light defined by x = 0.1935, y = 0.7179 in the chromaticity coordinate systems was observed. In this example, the measurement was carried out through the integrating sphere.

### Production Example 9, not forming part of the present invention

1.5 parts of StellarGreen E-8 (fluophor produced by Swada) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused blue green light defined by x = 0.1928, y = 0.5244 in the chromaticity coordinate systems was observed. In this example, the measurement was carried out through the integrating sphere.

### Production Example 10, not forming part of the present invention

5 parts of Blaze E-5 (fluophor produced by Swada) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused red light defined by x = 0.6505, y = 0.3414 in the chromaticity coordinate systems was observed. In this example, the measurement was carried out through the integrating sphere.

### Production Example 11, not forming part of the present invention

5 parts of Lunary Yellow E-27 (fluophor produced by Swada) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused yellow green light defined by x = 0.3475, y = 0.6231 in the chromaticity coordinate systems was observed. In this example, the measurement was carried out through the integrating sphere.

### Production Example 12, not forming part of the present invention

1.5 parts of NKP-8304 (fluophor produced by Nippon Keiko Kagakusha) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused pink light defined by x = 0.5165, y = 0.3536 in the chromaticity coordinate systems was observed. In this example, the measurement was carried out through the integrating sphere.

### Production Example 13, not forming part of the present invention

1.5 parts of NKP-8301 (fluophor produced by Nippon Keiko Kagakusha) were dispersed as fluorescent substance in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused reddish violet light defined by x = 0.4730, y = 0.2890 in the chromaticity coordinate systems was observed. In this example, the measurement was carried out through the integrating sphere.

### Production Example 14, not forming part of the present invention

1.5 parts of NKP-8301 (fluophor produced by Nippon Keiko Kagakusha) were dispersed as fluorescent substance in silicone rubber, and a fluorescent color cap having a thickness of 0.5 mm was molded using a mold and a heat press. When this color cap was mounted on a green LED which emits a light defined by x = 0.4686, y = 0.5282 in the chromaticity coordinate systems, a diffused orange light defined by x = 0.5720, y = 0.4253 in the chromaticity coordinate systems was observed. In this example, the measurement was carried out through the integrating sphere.

### Production Example 15, not forming part of the present invention

1.5 parts of NKP-8304 (fluophor produced by Nippon Keiko Kagakusha) were dispersed as fluorescent substance in silicone rubber, and a fluorescent color cap having a thickness of 0.5 mm was molded using a mold and a heat press. When this color cap was mounted on a green LED which emits a light defined by x = 0.4686, y = 0.5282 in the chromaticity coordinate systems, a diffused orange light having a yellow tint which is defined by x = 0.5457, y = 0.4522 in the chromaticity coordinate systems was observed. In this example, the measurement was carried out through the integrating sphere.

### Production Example 16, not forming part of the present invention

NKP-8315 (fluophor produced by Nippon Keiko Kagakusha) and NKP-8304 (fluophor produced by Nippon Keiko Kagakusha) were mixed as fluorescent substance at a ratio of 10:1. 0.75 parts of this mixture were dispersed in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a green tint which is defined by x = 0.3486, y = 0.4595 in the chromaticity coordinate systems was observed. In this example, the measurement was carried out through the integrating sphere.

### Production Example 17, not forming part of the present invention

NKP-8315 (fluophor produced by Nippon Keiko Kagakusha) and NKP-8304 (fluophor produced by Nippon Keiko Kagakusha) were mixed as fluorescent substance at a ratio of 10:3. 0.75 parts of this mixture were dispersed in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a yellow tint which is defined by x = 0.4107, y = 0.4198 in the chromaticity coordinate systems was observed. In this example, the measurement was carried out through the integrating sphere.

### Production Example 18, not forming part of the present invention

NKP-8315 (fluophor produced by Nippon Keiko Kagakusha) and NKP-8304 (fluophor produced by Nippon Keiko Kagakusha) were mixed as fluorescent substance at a ratio of 10:5. 0.75 parts of this mixture were dispersed in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having an orange tint which is defined by x = 0.4445, y = 0.4070 in the chromaticity coordinate systems was observed. In this example, the measurement was carried out through the integrating sphere.

### Production Example 19, not forming part of the present invention

NKP-8315 (fluophor produced by Nippon Keiko Kagakusha) and NKP-8304 (fluophor produced by Nippon Keiko Kagakusha) were mixed as fluorescent substance at a ratio of 10:10. 0.75 parts of this mixture were dispersed in silicone rubber, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a diffused white light having a red tint which is defined by x = 0.4634, y = 0.3839 in the chromaticity coordinate systems was observed. In this example, the measurement was carried out through the integrating sphere.

As is clear from the results of the diffused lights seen in the production examples 16 to 19, the color of the LED can freely be changed by arbitrarily changing a combination of a variety of fluorescent substances and a mixing ratio and a concentration thereof.

### Production Example 20, not forming part of the present invention

1.5 parts of NKP-8306 (fluophor produced by Nippon Keiko Kagakusha) were dispersed as fluorescent substance in Akylbet MD (Mitsubishi Rayon Co., Ltd.) which is an acrylic resin, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a result similar to that of the example 1 was obtained. In this example, the measurement was carried out through the integrating sphere.

### Production Example 21, not forming part of the present invention

1.5 parts of NKP-8306 (fluophor produced by Nippon Keiko Kagakusha) were dispersed as fluorescent substance in Mitsubishi Polyethy-HD HJ390 (Mitsubishi Chemical Co., Ltd.) which is a high density polystyrene, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a result similar to that of the example 1 was obtained. In this example, the measurement was carried out through the integrating sphere.

### Production Example 22, not forming part of the present invention

1.5 parts of NKP-8306 (fluophor produced by Nippon Keiko Kagakusha) were dispersed as fluorescent substance in Cepton 2043 (Kuraray Co., Ltd.) which is a styrene thermoplastic elastomer, and a fluorescent color cap having a thickness of 0.5 mm was molded using a mold and a heat press. When this color cap was mounted on a blue LED which emits a light defined by x = 0.1490, y = 0.1203 in the chromaticity coordinate systems, a result similar to that of the example 1 was obtained. In this example, the measurement was carried out through the integrating sphere.

### Production Example 23, not forming part of the present invention

40 parts of YAG fluophor (yttrium 28.0 wt%, aluminum 13.6 wt%, gadolinium 56.62 wt%, cerium 1.23 wt%), were dispersed as fluorescent substance in silicone rubber, and a fluorescent color cap having a thickness of 0.6 mm was molded using a mold and a heat press.

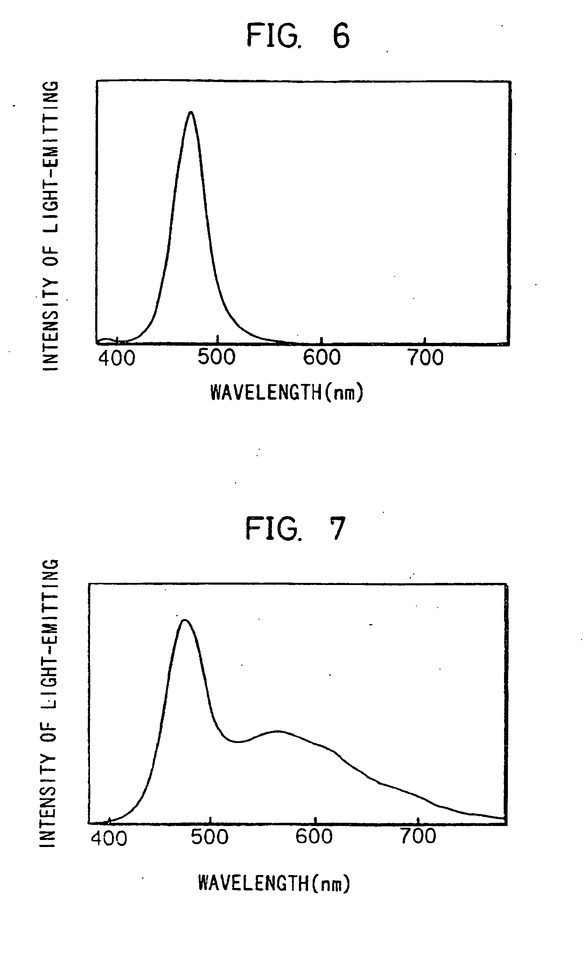

Further, a blue LED which emits a light defined by x = 0.1275, y = 0.0883 in accordance with the chromaticity coordinate systems and having a luminance of 28.95 cd/m² was used. FIG. 6 shows a spectral wavelength of this blue LED. When this blue LED was caused to emit a light with the fluorescent color cap mounted thereon, a diffused white light defined by x = 0.3192, y = 0.3375 in the chromaticity coordinate systems and having a luminance of 66.36 cd/m² was observed. The spectral wavelength at this time is shown in FIG. 7. In this example, the measurement was carried out through the integrating sphere.

### Production Example 24

12.5 parts of YAG fluophor (yttrium 28.0 wt%, aluminum 13.6 wt%, gadolinium 56.62 wt%, cerium 1.23 wt%), were dispersed as fluorescent substance in silicone rubber, and an elastic sheet having a thickness of 0.5 mm was produced.

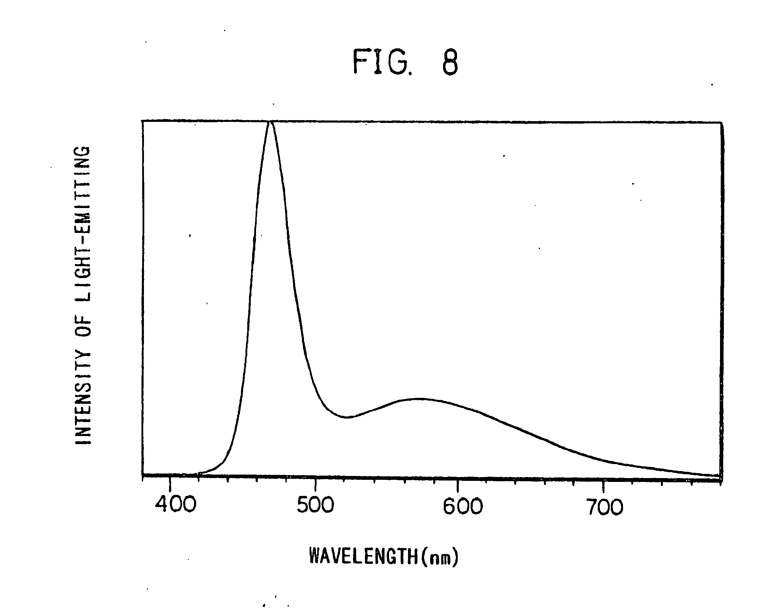

Using the blue LED used in the production example 23, the above elastic sheet was mounted in a position 5 mm away from the blue LED, which was then turned on by applying a current of 20 mA. Upon measuring a light diffused by passing through the elastic sheet, a diffused white light defined by x = 0.2667, y = 0.2725 in the chromaticity coordinate systems and having a luminance of 1629 cd/m² was observed. The spectral wavelength at this time is shown in FIG. 8. In this example, the measurement was carried out not through the integrating sphere.

### Production Example 25, not forming part of the present invention

0.2 parts of "Lumogen ORANGE F" (produced by BASF GmbH) which is a perylene fluorescent dye having a light gathering property were dispersed as fluorescent substance in silicone rubber, and a fluorescent color cap having a thickness of 0.5 mm was produced using a mold and a heat press.

Using the blue LED used in the production example 23, the above fluorescent color cap was mounted on the blue L-ED, which was then turned on by applying a current of 20 mA. As a result, a diffused white light defined by x = 0.3405, y = 0.3235 in the chromaticity coordinate systems and having a luminance of 2.124 cd/m² was observed. In this example, the measurement was carried out through the integrating sphere.

### Production Example 26, not forming part of the present invention

0.2 parts of "Lumogen ORANGE F" (produced by BASF GmbH) which is a perylene fluorescent dye having a light gathering property were dispersed as fluorescent substance in silicone rubber, and a fluorescent color cap having a thickness of 0.5 mm was produced using a mold and a heat press.

Using the blue LED used in the production example 23, the above fluorescent color cap was mounted on the blue LED, which was then turned on by applying a current of 20 mA. As a result, a yellow green light defined by x = 0.1859, y = 0.6108 in the chromaticity coordinate systems and having a luminance of 2.708 cd/m² was observed. In this example, the measurement was carried out through the integrating sphere.

### Production Example 27, not forming part of the present invention

40 parts of YAG fluophor used in the production example 23 were mixed and dispersed in silicone rubber, and a fluorescent color cap having a thickness of 0.6 mm was produced using a mold and a heat press. A lens-shaped cap made of silicone rubber having a transmittance of 80 % or greater was mounted on a leading end portion of the fluorescent color cap. This fluorescent color cap was mounted on a blue LED, which was then turned on by applying a current of 20 mA. The chromaticity coordinates and luminance were measured from the front of the leading end portion of the LED. The measurement results are shown in TABLE-2. In this example, the measurement was carried out not through the integrating sphere.

**TABLE-2**

| | X | y | Luminance (cd/m²) |
|---|---|---|---|
| Cap Mounted | 0.3446 | 0.3482 | 3667 |
| Lens-Equipped Cap Mounted | 0.3348 | 0.3359 | 6239 |

By providing the lens at the leading end portion of the fluorescent cap, the luminance of the light emitted from the front surface could be increased by about 70 % without changing the luminescent color.

### Production Example 28, not forming part of the present invention

12.5 parts of YAG fluophor (yttrium 28.0 wt%, aluminum 13.6 wt%, gadolinium 56.62 wt%, cerium 1.23 wt%) were dispersed as fluorescent substance in silicone rubber, and a fluorescent color cap having a thickness of 0.6 mm was produced using a mold and a heat press.

Using the blue LED used in the production example 23, the above fluorescent color cap was mounted on the blue LED, which was then turned on by applying a current of 20 mA. As a result, a diffused white light defined by x = 0.3192, y = 0.3375 in the chromaticity coordinate systems and having a luminance of 66.36 cd/m² was observed.

On the other hand, 0.03 parts of condensation azo dye were dispersed as a red coloring agent in silicone rubber, and a colored cap having a thickness of 0.5 mm was molded using a mold and a heat press.

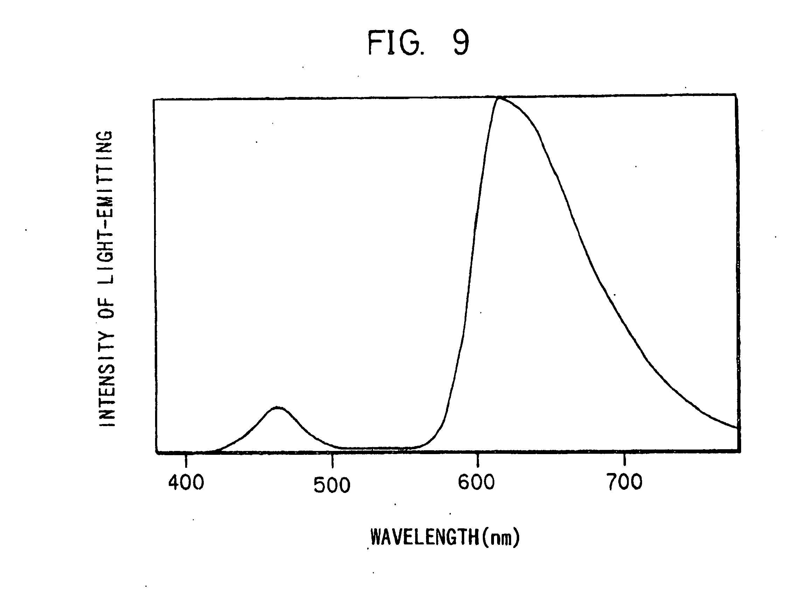

This colored cap was mounted on the LED having the fluorescent color cap mounted thereon, and the LED was caused to emit a light. As a result, a diffused red light defined by x = 0.5997, y = 0.3081 in the chromaticity coordinate systems and having a luminance of 9.813 cd/m² was observed. The spectral wavelength at this time is shown in FIG. 9. In this example, the measurement was carried out through the integrating sphere.

### Production Example 29, not forming part of the present invention

0.03 parts of phthalocyanine green were dispersed as a green coloring agent in silicone rubber, and a colored cap having a thickness of 0.5 mm was molded using a mold and a heat press.

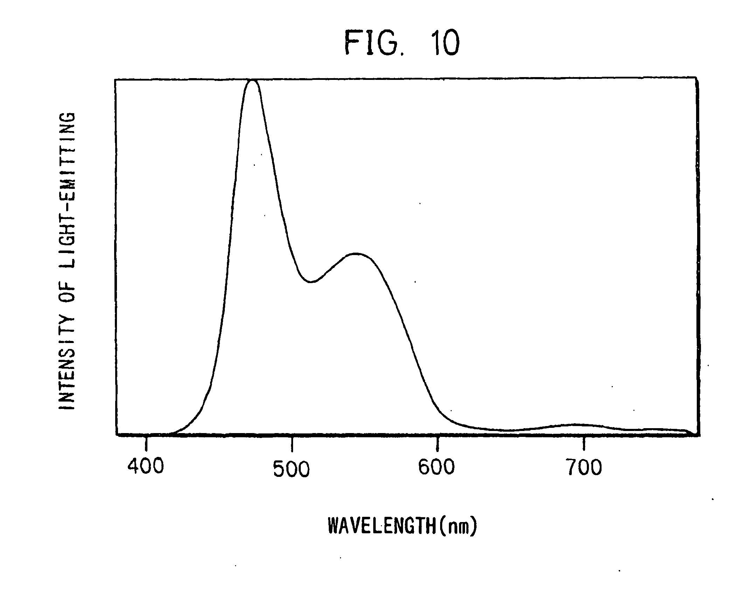

Similar to the production example 28, this colored cap was mounted on the LED having the fluorescent color cap mounted thereon, and the LED was caused to emit a light. As a result, a diffused green light defined by x = 0.2127, y = 0.3702 in the chromaticity coordinate systems and having a luminance of 32.38 cd/m² was observed. The spectral wavelength at this time is shown in FIG. 10. In this example, the measurement was carried out through the integrating sphere.

### Production Example 30, not forming part of the present invention

A colored cap was molded in the same way as in the production example 29 except that an amount of the green coloring agent in use was changed from 40 parts to 80 parts. This colored cap was mounted on the LED having the fluorescent color cap mounted thereon, and the LED was caused to emit a light. As a result, a diffused green light defined by x = 0.1859, y = 0.3971 in the chromaticity coordinate systems and having a luminance of 22.34 cd/m² was observed. In this example, the measurement was carried out through the integrating sphere.

### Production Example 31, not forming part of the present invention

0.03 parts of phthalocyanine blue were dispersed as a blue coloring agent in silicone rubber, and a colored cap having a thickness of 0.5 mm was molded using a mold and a heat press.

Similar to the production example 28, this colored cap was mounted on the LED having the fluorescent color cap mounted thereon, and the LED was caused to emit a light. As a result, a diffused blue light defined by x = 0.1236, y = 0.1585 in the chromaticity coordinate systems and having a luminance of 10.19 cd/m² was observed. In this example, the measurement was carried out through the integrating sphere.

As is clear from the results of the production examples 28 to 31, a desired luminescent color can be obtained if a colored cap containing a coloring agent of a desired color is further mounted on the LED which is enabled to have a white luminescent color by mounting the fluorescent color cap.

### Production Example 32, not forming part of the present invention

40 parts of YAG fluophor (yttrium 28.0 wt%, aluminum 13.6 wt%, gadolinium 56.62 wt%, cerium 1.23 wt%) as fluorescent substance and 0.03 parts of condensation azo dye as a red coloring agent were dispersed in silicone rubber, and a fluorescent color cap having a thickness of 0.5 mm was produced using a mold and a heat press.

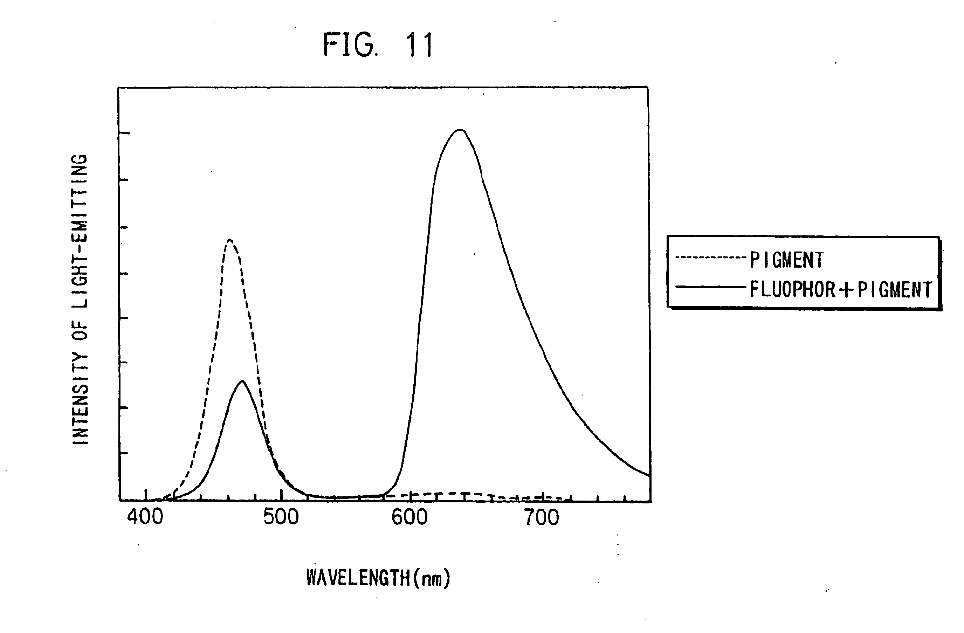

This fluorescent color cap was mounted on a blue LED, which was then caused to emit a light. Then, a blue light defined by x = 0.1275, y = 0.0883 in the chromaticity coordinate systems and having a luminance of 2.895 cd/m² became a diffused red light having a color defined by x = 0.5289, y = 0.2542 and a luminance of 0.9259 cd/m² after the mounting of the cap. A luminous intensity in relation to wavelength at this time is shown in FIG. 11. In this example, the measurement was carried out through the integrating sphere.

As is clear from the production example 32, a desired luminescent color can also be obtained by containing a coloring agent of a desired color in the fluorescent color cap.

### Production Example 33

23 parts of YAG fluophor (yttrium 28.0 wt%, aluminum 13.6wt%, gadolinium 56.62 wt%, cerium 1.23 wt%) were dispersed as fluorescent substance in silicone rubber, and a fluorescent color cap, not forming part of the present invention having a thickness of 0.35 mm was produced.

Using the blue LED used in the production example 23, the above cap was mounted on this blue LED, which was then turned on by applying a current of 20 mA. Lights emitted from the leading end portion and the side surface portion of the cap were measured by the spectrophotometer. The results are shown in TABLE-3. In this example, the measurement was carried out not through the integrating sphere.

**TABLE-3**

| Place of Measurement | X | y | Luminance (cd/m²) |
|---|---|---|---|
| Leading End | 0.2346 | 0.2365 | 2954 |
| Side Surface | 0.3095 | 0.3389 | 2053 |

Next, 12 parts of YAG fluophor (yttrium 28.0 wt%, aluminum 13.6wt%, gadolinium 56.62 wt%, cerium 1.23 wt%) were dispersed as fluorescent substance in silicone rubber, and a sheet piece having a thickness of 0.35 mm was produced. After mounting this sheet piece on the leading end of the cap, the chromaticity was measured again by the spectrophotometer. The result is shown in TABLE-4.

**TABLE-4**

| Place of Measurement | X | y | Luminance (cd/m²) |
|---|---|---|---|
| Leading End | 0.306 | 0.3355 | 2985 |

From these results, it can be seen that the chromaticity of the light diffused while passing through the coating member can be adjusted by changing the concentration of the fluorescent substance in the coating member.

### Production Example 34, not forming part of the present invention

Using a blue LED having a diameter of 3 mm, the color of the light emitted from this LED was changed by changing a value of a current flowing into the LED. A fluorescent color cap (thickness: 0.6 mm) containing a specific amount of YAG fluophor was mounted, and the luminescent color and the luminance after the mounting of the cap were measured by the spectrophotometer. The measurement results are shown in TABLE-5. In this example, the measurement was carried out through the integrating sphere.

**TABLE-5**

| Current mA | x | Y | Luminance | YAG Amount | x | y | Luminance |
|---|---|---|---|---|---|---|---|
| 5 | 0.1213 | 0.1063 | 9.71 | 5.0 | 0.2189 | 0.2320 | 14.11 |
| | | | | 10.0 | 0.2886 | 0.3165 | 20.51 |
| | | | | 15.0 | 0.3397 | 0.3767 | 23.85 |
| 10 | 0.1243 | 0.0972 | 16.48 | 5.0 | 0.2210 | 0.2216 | 29.85 |
| | | | | 10.0 | 0.2894 | 0.3076 | 40.66 |
| | | | | 10.5 | 0.2925 | 0.3105 | 43.39 |
| | | | | 15.0 | 0.3393 | 0.3694 | 43.67 |
| 20 | 0.1275 | 0.0883 | 28.95 | 5.0 | 0.2214 | 0.2132 | 53.23 |
| | | | | 10.0 | 0.2888 | 0.2991 | 70.99 |
| | | | | 11.0 | 0.2989 | 0.3102 | 78.56 |
| | | | | 15.0 | 0.3380 | 0.3612 | 81.28 |
| 30 | 0.1288 | 0.0848 | 38.51 | 5.0 | 0.2214 | 0.2094 | 71.30 |
| | | | | 10.0 | 0.2878 | 0.2957 | 96.22 |
| | | | | 11.5 | 0.3046 | 0.3124 | 111.00 |
| | | | | 15.0 | 0.3377 | 0.3577 | 109.99 |

From TABLE-5, it can be seen that, even if there is a variation in the luminescent color of the LED, the luminescent color can be adjusted within a specified range by mounting the fluorescent color cap containing the specific amount of fluorescent substance.

As described above, according to the inventive coating member containing the fluorescent substance, the luminescent color of the LED can be changed to a desired color including white by mounting this coating member on the LED.

Further, since the luminescent color is changed by exciting the wavelength of the light emitted from the LED by the fluorescent substance, a stable color balance can be obtained by a single LED. Further, since the cap-shaped coating member, not forming part of the present invention is molded, it is precise in dimension and easy to maintain. Furthermore, since this cap is directly mounted on the LED, no special space is necessary and can be mounted regardless of the shape of the LED.

## Claims

1. A transparent coating member (3) to be placed on the surface of and adhered to a light-emitting diode (4), said transparent coating member (3) being made of a silicone elastomer as a bonding resin and comprising an inorganic fluorescent substance **characterised in that** the transparent coating member is in a form of a sheet and the inorganic fluorescent substance is selected from a group consisting of aluminates, phosphates and silicates, the inorganic fluorescent substance being in a range of 0.5 to 70 weight parts per 100 weight parts of the silicone elastomer.

2. A transparent coating member (3) according to claim 1, wherein the fluorescent substance is an inorganic aluminate.

3. A transparent coating member (3) according to claim 1 or 2, wherein the fluorescent substance is an yttrium aluminate.

4. The transparent coating member (3) according to anyone of claims 1 to 3, wherein an additive selected from the group consisting of cerium, europium, manganese, gadolinium, samarium, terbium, tin and chromium, is added to the fluorescent substance.

5. The transparent coating member (3) according to claim 3, wherein the yttrium aluminate further includes cerium and gadolinium.

6. A fluorescent color light source comprising:
a light-emitting diode (4); and
a transparent coating member (3) placed on the surface of and adhered to the light-emitting diode (4),
said transparent coating member (3) being made of a silicone elastomer as a bonding resin and comprising an inorganic fluorescent substance, whereby the wavelength of the light emitted by the light-emitting diode (4) is changed by the fluorescent substance contained in the transparent coating member (3) to change the luminescent color, **characterised in that** the transparent coating member is in a form of a sheet and the inorganic fluorescent substance is selected from a group consisting of aluminates, phosphates and silicates, the inorganic fluorescent substance being in a range of 0.5 to 70 weight parts per 100 weight parts of the silicone elastomer selected from a group consisting of aluminates, phosphates and silicates, the inorganic fluorescent substance being in a range of 0.5 to 70 weight parts per 100 weight parts of the silicone elastomer.

7. The fluorescent color light source according to claim 6, wherein the fluorescent substance is an inorganic aluminate.

8. The fluorescent color light source according to claim 6 or 7, wherein the fluorescent substance is an yttrium aluminate.

9. The fluorescent color light source according to anyone of claims 6 to 8, wherein an additive selected from the group consisting of cerium, europium, manganese, gadolinium, samarium, terbium, tin and chromium, is added to the fluorescent substance.

10. The fluorescent color light source according to claim 8, wherein the yttrium aluminate further includes cerium and gadolinium.

11. The fluorescent color light source according to anyone of claims 6 to 10, wherein the light diffusely emitted through the transparent coating member (3) has a luminescent color within a range defined by (x, y) = (0.148, 0,123), (0.199, 0.718), (0.651, 0.341) and (0.348, 0.623) in chromaticity coordinate systems.

12. The fluorescent color light source according to anyone of claims 6 to 10, wherein the light diffusely emitted through the transparent coating member (3) has a luminescent color within a range defined by (x, y) = (0.27, 0.19), (0.19, 0.24), (0.35, 0.48) and (0.48, 0.37) in chromaticity coordinate systems.

13. The fluorescent color light source according to anyone of claims 6 to 12, further comprising a secondary coating member mounted or formed on the transparent coating member (3), the secondary coating member containing a coloring agent.

14. The fluorescent color light source according to anyone of claims 6 to 13, wherein the light-emitting diode (4) is a light-emitting diode which emits blue light.

15. The fluorescent color light source according to anyone of claims 6 to 13, wherein the light-emitting diode (4) is a light-emitting diode which emits green light.

16. The fluorescent color light source according to anyone of claims 6 to 15, wherein the light-emitting diode (4) is a chip-type light-emitting diode or a segment type light-emitting diode.

## Patentansprüche

1. Transparentes Beschichtungselement (3), anzuordnen auf der Oberfläche von und befestigt an eine Licht-emittierende Diode (4), wobei das transparente Beschichtungselement (3) aus einem Silikonelastomer als ein bindendes Harz hergestellt ist und eine anorganische fluoreszierende Substanz umfaßt, **dadurch gekennzeichnet, daß** das transparente Beschichtungselement in der Form einer Schicht bzw. Lage bzw. Blatt ist und die anorganische fluoreszierende Substanz aus einer Gruppe ausgewählt ist, bestehend aus Aluminaten, Phosphaten und Silikaten, wobei die anorganische fluoreszierende Substanz in einem Bereich von 0,5 bis 70 Gew.-Teilen pro 100 Gew.-Teilen des Silikonelastomers vorliegt.

2. Transparentes Beschichtungselement (3) gemäß Anspruch 1, wobei die fluoreszierende Substanz ein anorganisches Aluminat ist.

3. Transparentes Beschichtungselement (3) gemäß Anspruch 1 oder 2, wobei die fluoreszierende Substanz ein Yttriumaluminat ist.

4. Transparentes Beschichtungselement (3) gemäß einem der Ansprüche 1 bis 3, wobei ein Additiv, ausgewählt aus der Gruppe, bestehend aus Cer, Europium, Mangan, Gadolinium, Samarium, Terbium, Zinn und Chrom, zu der fluoreszierenden Substanz gegeben ist.

5. Transparentes Beschichtungselement (3) gemäß Anspruch 3, wobei das Yttriumaluminat weiter Cer und Gadolinium einschließt.

6. Fluoreszenzfarblichtquelle, umfassend:
eine Licht-emittierende Diode (4);
ein transparentes Beschichtungselement (3), angeordnet auf der Oberfläche von und befestigt an die Licht-emittierende Diode (4), wobei das transparente Beschichtungselement (3) aus einem Silikonelastomer als ein bindendes Harz hergestellt ist und eine anorganische fluoreszierende Substanz umfaßt, wobei die Wellenlänge des durch die Licht-emittierende Diode (4) emittierten Lichts durch die fluoreszierende Substanz in dem transparenten Beschichtungselement (3) verändert wird, um die Lumineszenzfarbe zu ändern, **dadurch gekennzeichnet, daß** das transparente Beschichtungselement in der Form einer Lage ist und die anorganische fluoreszierende Substanz aus einer Gruppe ausgewählt ist, bestehend aus Aluminaten, Phosphaten und Silikaten, wobei die anorganische fluoreszierende Substanz in einem Bereich von 0,5 bis 70 Gew.-Teilen pro 100 Gew.-Teilen des Silikonelastomers vorliegt.

7. Fluoreszentfarblichtquelle gemäß Anspruch 6, wobei die fluoreszierende Substanz ein anorganisches Aluminat ist.

8. Fluoreszenzfarblichtquelle gemäß Anspruch 6 oder 7, wobei die fluoreszierende Substanz ein Yttriumaluminat ist.

9. Fluoreszenzfarblichtquelle gemäß einem der Ansprüche 6 bis 8, wobei ein Additiv, ausgewählt aus der Gruppe, bestehend aus Cer, Europium, Mangan Gadolinium, Samarium, Terbium, Zinn und Chrom, zu der fluoreszierenden Substanz gegeben ist.

10. Fluoreszenzfarblichtquelle gemäß Anspruch 8, wobei das Yttriumaluminat weiter Cer und Gadolinium einschließt.

11. Fluoreszenzfarblichtquelle nach einem der Ansprüche 6 bis 10, wobei das durch das transparente Beschichtungselement diffus emittierte Licht eine Lumineszenzfarbe innerhalb eines Bereiches, definiert durch (x, y) = (0,148, 0,123), (0,199, 0,718), (0,651, 0,341) und (0,348, 0,623) in Farbart-Koordinatensystemen, aufweist.

12. Fluoreszenzfarblichtquelle nach einem der Ansprüche 6 bis 10, wobei das durch das transparente Beschichtungselement (3) diffus emittierte Licht eine Lumineszenzfarbe innerhalb eines Bereiches, definiert durch (x, y) = 0,27, 0,19), (0,19, 0,24), (0,35, 0,48) und (0,48, 0,37) in Farbart-Koordinatensystemen aufweist.

13. Fluoreszenzfarblichtquelle nach einem der Ansprüche 6 bis 12, weiter umfassend ein sekundäres Beschichtungselement, angebracht oder gebildet auf dem transparenten Beschichtungselement (3), wobei das sekundäre-Beschichtungselement ein Färbemittel enthält.

14. Fluoreszenzfarblichtquelle nach einem der Ansprüche 6 bis 13, wobei die Licht-emittierende Diode (4) eine licht-emittierende Diode ist, welche blaues Licht emittiert.

15. Fluoreszenzfarblichtquelle nach einem der Ansprüche 6 bis 13, wobei die Licht-emittierende Diode (4) eine Licht-emittierende Diode ist, welche grünes Licht emittiert.

16. Fluoreszenzfarblichtquelle nach einem der Ansprüche 6 bis 15, wobei die Licht-emittierende Diode (4) eine Licht-emittierende Diode vom Chip-Typ oder eine Licht-emittierende Diode vom Segment-Typ ist.

## Revendications

1. Elément de revêtement transparent (3) à placer sur la surface d'une diode électroluminescente (4) et à coller à cette dernière, ledit élément de revêtement transparent (3) étant composé d'un élastomère de silicone en tant que résine liante et comprenant une substance fluorescente inorganique, **caractérisé en ce que** l'élément de revêtement transparent a la forme d'une feuille et la substance fluorescente inorganique est sélectionnée dans un groupe composé d'aluminates, de phosphates et de silicates, la substance fluorescente inorganique étant dans une plage de 0,5 à 70 parties en poids par 100 parties en poids de l'élastomère de silicone.

2. Elément de revêtement transparent (3) selon la revendication 1, dans lequel la substance fluorescente est un aluminate inorganique.

3. Elément de revêtement transparent (3) selon la revendication 1 ou 2, dans lequel la substance fluorescente est un aluminate d'yttrium.

4. Elément de revêtement transparent (3) selon l'une quelconque des revendications 1 à 3, dans lequel un additif sélectionné dans le groupe composé du cérium, de l'europium, du manganèse, du gadolinium, du samarium, du terbium, de l'étain et du chrome, est ajouté à la substance fluorescente.

5. Elément de revêtement transparent (3) selon la revendication 3, dans lequel l'aluminate d'yttrium comprend en outre le cérium et le gadolinium.

6. Source de lumière colorée fluorescente comprenant :
une diode électroluminescente (4) ; et
un élément de revêtement transparent (3) placé sur la surface de la diode électroluminescente (4) et à coller à cette dernière,
ledit élément de revêtement transparent (3) étant composé d'un élastomère de silicone en tant que résine liante et comprenant une substance fluorescente inorganique, moyennant quoi la longueur d'onde de la lumière émise par la diode électroluminescente (4) est modifiée par la substance fluorescente contenue dans l'élément de revêtement transparent (3) afin de modifier la couleur luminescente, **caractérisée en ce que** l'élément de revêtement transparent a la forme d'une feuille et la substance fluorescente inorganique est sélectionnée dans un groupe composé d'aluminates, de phosphates et de silicates, la substance fluorescente inorganique étant dans une plage de 0,5 à 70 parties en poids par 100 parties en poids de l'élastomère de silicone.

7. Source de lumière colorée fluorescente selon la revendication 6, dans laquelle la substance fluorescente est un aluminate inorganique.

8. Source de lumière colorée fluorescente selon la revendication 6 ou 7, dans laquelle la substance fluorescente est un aluminate d'yttrium.

9. Source de lumière colorée fluorescente selon l'une quelconque des revendications 6 à 8, dans laquelle un additif sélectionné dans le groupe composé du cérium, de l'europium, du manganèse, du gadolinium, du samarium, du terbium, de l'étain et du chrome, est ajouté à la substance fluorescente.

10. Source de lumière colorée fluorescente selon la revendication 8, dans laquelle l'aluminate d'yttrium comprend en outre du cérium et du gadolinium.

11. Source de lumière colorée fluorescente selon l'une quelconque des revendications 6 à 10, dans laquelle la lumière émise de manière diffuse par l'intermédiaire de l'élément de revêtement transparent (3) possède une couleur luminescente dans une plage définie par (x, y) = (0,148, 0,123), (0,199, 0,718), (0,651, 0,341) et (0,348, 0,623) dans des systèmes de coordonnées trichromatiques.

12. Source de lumière colorée fluorescente selon l'une quelconque des revendications 6 à 10, dans laquelle la lumière émise de manière diffuse par l'intermédiaire de l'élément de revêtement transparent (3) possède une couleur luminescente dans une plage définie par (x, y) = (0,27, 0,19), (0,19, 0,24), (0,35, 0,48) et (0,48, 0,37) dans des systèmes de coordonnées trichromatiques.

13. Source de lumière colorée fluorescente selon l'une quelconque des revendications 6 à 12, comprenant en outre un élément de revêtement secondaire monté ou formé sur l'élément de revêtement transparent (3), l'élément de revêtement secondaire contenant un agent colorant.

14. Source de lumière colorée fluorescente selon l'une quelconque des revendications 6 à 13, dans laquelle la diode électroluminescente (4) est une diode électroluminescente qui émet une lumière bleue.

15. Source de lumière colorée fluorescente selon l'une quelconque des revendications 6 à 13, dans laquelle la diode électroluminescente (4) est une diode électroluminescente qui émet une lumière verte.

16. Source de lumière colorée fluorescente selon l'une quelconque des revendications 6 à 15, dans laquelle la diode électroluminescente (4) est une diode électroluminescente de type puce ou une diode électroluminescente de type segment.
